# EUROPEAN PATENT SPECIFICATION

(11) **EP 4 166 950 B1**
(45) Date of publication and mention of the grant of the patent: **21.08.2024**
(21) Application number: 22200385.7
(22) Date of filing: 07.10.2022
(51) Int. Cl.: G01R 19/25

(54) **ELECTRICAL PARAMETER MONITORING**
ÜBERWACHUNG ELEKTRISCHER PARAMETER
SURVEILLANCE DE PARAMÈTRES ÉLECTRIQUES

(30) Priority: 16.10.2021 US 202117503265
(43) Date of publication of application: 19.04.2023
(73) Proprietor: Elspec Engineering Ltd., 38900 Caesarea Industrial Park (IL)
(72) Inventor: HARARY, Yoram, 3097317 Narkis 6, Caesarea (IL); HARARY, Oren, 6936104 Levi Eshkol 17 ,Tel Aviv-Yafo (IL); HARARI, Nadav, 4815236 Aluf Harav Goren 43, Rosh HaAyin (IL); LAIFER, Asaf, 6082182 Dekel 4, Shoham (IL)
(74) Representative: Pearl Cohen Zedek Latzer Baratz UK LLP

(56) References cited:
- CN-A- 110 336 289
- US-A1- 2020 292 608
- BALDUCELLI ET AL: "Safeguarding information intensive critical infrastructures against novel types of emerging failures", RELIABILITY ENGINEERING AND SYSTEM SAFETY, ELSEVIER APPLIED SCIENCE, GB, vol. 92, no. 9, 6 March 2007 (2007-03-06), pages 1218 - 1229, XP005916442, ISSN: 0951-8320, DOI: 10.1016/J.RESS.2006.08.006
- FORUZAN ELHAM ET AL: "Fast sliding detrended fluctuation analysis for online frequency-event detection in modern power systems", 2017 NORTH AMERICAN POWER SYMPOSIUM (NAPS), IEEE, 17 September 2017 (2017-09-17), pages 1 - 6, XP033256122, DOI: 10.1109/NAPS.2017.8107294

## Description

### FIELD OF THE INVENTION

The present invention relates to electrical networks. More particularly, the present invention relates to monitoring of electrical parameters in electrical networks.

### BACKGROUND OF THE INVENTION

A typical electrical network is configured to provide electrical power to one or more consumers or devices. For example, the electrical network may include one or more power stations where electrical power is generated. The electrical power may be transmitted via a network of transmission lines and feeder lines. For example, electrical power may be transmitted along transmission lines at a high voltage from an electrical power station to one or more substations. The electrical power may be distributed by the substation to one or more types of loads (e.g., devices that utilize electrical power for performing mechanical work or for conversion to other forms of energy) at lower voltages via feeder lines.

The document, BALDUCELLI ET AL: "Safeguarding information intensive critical infrastructures against novel types of emerging failures", RELIABILITY ENGINEERING AND SYSTEM SAFETY, ELSEVIER APPLIED SCIENCE, GB, discloses a SCADA system which uses a variable length sliding window for the evaluation of parameters detected in an electrical network.

### SUMMARY OF THE INVENTION

There is thus provided, in accordance with an embodiment of the invention, a method of monitoring a parameter of an electrical network, the method including: using one or a plurality of sensors in the electrical network, measuring a value of a parameter of the electrical network during each sampling period within a selected time section; using the processor, during each iteration of a plurality of iterations of a sliding window algorithm, wherein within each of the iterations a starting time of a sliding window of the sliding window algorithm within the selected time section is incremented by a selected increment, a duration of the sliding window in each iteration of the iterations being different from the duration of sliding windows in other iterations of the plurality of iterations of the sliding window algorithm, calculating an average of the measured parameter values over the duration of the sliding window for each of the starting times; using the processor, calculating a representative value of the calculated averages of the parameter for each iteration; and using the processor, issuing an alert if the representative value indicates a need for an alert.

Furthermore, in accordance with an embodiment of the invention, measuring a value of a parameter includes measuring a root mean square value of the parameter.

Furthermore, in accordance with an embodiment of the invention, a duration of the sampling period is one cycle of electric current in the electrical network.

Furthermore, in accordance with an embodiment of the invention, a duration of the sampling period is one half cycle of electric current in the electrical network.

Furthermore, in accordance with an embodiment of the invention, the parameter is selected from a group of parameters consisting of electric current, voltage and electric power.

Furthermore, in accordance with an embodiment of the invention, a minimum duration of the sliding window is equal to a duration of a single sampling period.

Furthermore, in accordance with an embodiment of the invention, a maximum duration of the sliding window is 10 seconds.

Furthermore, in accordance with an embodiment of the invention, a difference between durations of the sliding windows in successive iterations of the sliding window algorithm is equal to a duration of one sampling period.

Furthermore, in accordance with an embodiment of the invention, a duration of a sliding window in an iteration of the sliding window algorithm is determined in accordance with the calculated representative value during a previous iteration of the sliding window algorithm.

Furthermore, in accordance with an embodiment of the invention, during an iteration of the sliding window algorithm, the starting time of the sliding window is incremented by the duration of one sampling period.

Furthermore, in accordance with an embodiment of the invention, the representative value includes a predetermined percentile value of the average value of the parameter that is calculated in each iteration of the sliding window algorithm.

Furthermore, in accordance with an embodiment of the invention, the predetermined percentile value includes a maximum value.

Furthermore, in accordance with an embodiment of the invention, the measured parameter values are compressed.

There is further provided, in accordance with an embodiment of the invention, an intelligent electronic device to monitor a parameter of an electrical network, the device including: a sensor configured to measure a value of a parameter of the electrical network during each sampling period within a selected time section; and a processor configured to: during each iteration of a plurality of iterations of a sliding window algorithm, wherein within each of the iterations a starting time of a sliding window of the sliding window algorithm within the selected time section is incremented by a selected increment, a duration of the sliding window in each iteration of the iterations being different from the duration of the sliding windows in other iterations of the plurality of iterations of the sliding window algorithm, calculate an average of the measured parameter values over the duration of the sliding window for each of the starting times; and calculate a representative value of the calculated averages of the parameter for each iteration.

Furthermore, in accordance with an embodiment of the invention, the processor is further configured to determine if an action is indicated by the representative value.

Furthermore, in accordance with an embodiment of the invention, the device includes a communications module, wherein the action includes operating the communications module to send an alert.

### BRIEF DESCRIPTION OF THE DRAWINGS

In order for the present invention to be better understood and for its practical applications to be appreciated, the following Figures are provided and referenced hereafter. It should be noted that the Figures are given as examples only and in no way limit the scope of the invention. Like components are denoted by like reference numerals.
Fig. 1A schematically illustrates an electrical network that is monitored in accordance with an embodiment of the invention.
Fig. 1B schematically illustrates an intelligent electronic device for monitoring the electrical network in accordance with an embodiment of the invention.
Fig. 2 schematically illustrates an example of results of a measurement of a parameter of an electrical network once per cycle, for monitoring the parameter in accordance with an embodiment of the invention.
Fig. 3 schematically illustrates monitoring a parameter using sliding window calculations, in accordance with an embodiment of the invention.
Fig. 4 schematically illustrates a graph of a protection curve for use with monitoring an electrical network, in accordance with an embodiment of the invention.
Fig. 5 is a flowchart depicting a method of monitoring a parameter of an electrical network, in accordance with an embodiment of the invention.

### DETAILED DESCRIPTION OF THE INVENTION

In the following detailed description, numerous specific details are set forth in order to provide a thorough understanding of the invention. However, it will be understood by those of ordinary skill in the art that the invention may be practiced without these specific details. In other instances, well-known methods, procedures, components, modules, units and/or circuits have not been described in detail so as not to obscure the invention.

Although embodiments of the invention are not limited in this regard, discussions utilizing terms such as, for example, "processing," "computing," "calculating," "determining," "establishing", "analyzing", "checking", or the like, may refer to operation(s) and/or process(es) of a computer, a computing platform, a computing system, or other electronic computing device, that manipulates and/or transforms data represented as physical (e.g., electronic) quantities within the computer's registers and/or memories into other data similarly represented as physical quantities within the computer's registers and/or memories or other information non-transitory storage medium (e.g., a memory) that may store instructions to perform operations and/or processes. Although embodiments of the invention are not limited in this regard, the terms "plurality" and "a plurality" as used herein may include, for example, "multiple" or "two or more". The terms "plurality" or "a plurality" may be used throughout the specification to describe two or more components, devices, elements, units, parameters, or the like. Unless explicitly stated, the method embodiments described herein are not constrained to a particular order or sequence. Additionally, some of the described method embodiments or elements thereof can occur or be performed simultaneously, at the same point in time, or concurrently. Unless otherwise indicated, the conjunction "or" as used herein is to be understood as inclusive (any or all of the stated options).

Some embodiments of the invention may include an article such as a computer or processor readable medium, or a computer or processor non-transitory storage medium, such as for example a memory, a disk drive, or a USB flash memory, encoding, including or storing instructions, e.g., computer-executable instructions, which when executed by a processor or controller, carry out methods disclosed herein.

In accordance with an embodiment of the present invention, electrical parameters of an electrical network are monitored via one or more intelligent electronic devices. A typical intelligent electronic device may include one or more sensors or sensor circuitry for measuring one or more electrical parameters at a point of the electrical network, a processor for executing one or more algorithms in accordance with programmed instructions, and or more data storage units for storing one or more of measured values of the parameters, programmed instructions for operation of the processor, and calculated values that are the result of processing of the measured values. In addition, an intelligent electronic device may be provided with a communication module. The communication module may be configured to transmit a notification to a controller or operator of the electrical network, or to communicate with a controller for controlling one or more types of controllable components of the electrical network, such as relays, switches, circuit breakers, or other controllable components.

Electrical parameters may include, for example, voltage and current. Other parameters that are derivable from the voltage and current, e.g., power or other relevant parameters, may be calculated or measured by the intelligent electronic device. Each intelligent electronic device is configured to measure the relevant electrical parameters during the course of a sampling period and to record the values of the measured parameters. A typical sampling period may have a duration of one cycle or half cycle of alternating current (e.g., having a frequency of 60 Hz or 50 Hz). In addition, an intelligent electronic device may be configured to perform other functions. For example, the intelligent electronic device may communicate with a protection relay that operates a circuit breaker. The intelligent electronic device may calculate a value of a parameter for comparison with a set of values that indicate a need to open a circuit breaker. Other functions may include measuring a phasor (e.g., indicating a phase and magnitude of electric current or another parameter), and measuring the quality of provided electrical power.

A typical electrical network may include one or more power stations (e.g., including one or more generators that are powered by combustible fuel, nuclear power, solar energy, wind power, hydroelectric or tidal power, geothermal power, or other power sources, where electrical power is generated. The electrical power may be transmitted via a network of transmission lines and feeder lines. One or more substations may intervene between a power station and feeder lines that distribute electrical power to consumers. The electrical network may include one or more circuit breakers, e.g., each operated by a protection relay, that may interrupt transmission of electrical power along a given transmission line or feeder line. The electrical network may include one or more switched, e.g., operable by controller, to control the transmission of electrical power from the power station to a feeder line. For example, the controller may be configured modify a connection of one or more feeder lines to one or more power stations in order to accommodate a change in the load on a feeder line.

A plurality of intelligent electronic devices are connected to various transmission and feeder lines of the electrical network. For example, during a single sampling period, the intelligent electronic device may measure one or more parameters of a line of the electrical network to which that intelligent electronic device is connected. The intelligent electronic device may record a root mean square value of each parameter as measured or calculated during the sampling period. Use of data compression techniques, e.g., as described by Nisenblat et al. in US Patent number 7,415,370, may enable the intelligent electronic device to continuously monitor the parameters once per a sampling period of one cycle or one half cycle. Although, in examples discussed herein, measurements of parameters are described as being made once per a sampling period of one cycle, it may be noted that, in other examples, the sampling period may be one half cycle of the alternating current. In other examples, the duration of the sampling period may be shorter than one half cycle, may be longer than one cycle, or may be between one half cycle and one cycled.

Typically, each intelligent electronic device has a limited storage capacity for storing the recorded measured parameters. Thus, the intelligent electronic device may be configured to reduce the amount of stored by utilization of sliding windows of various lengths. The intelligent electronic device may then store representative data that results from application of the sliding window algorithm (e.g., a maximum value of a parameter for each length of the sliding window).

An operator or automated controller of the electrical network may indicate a starting time and ending time of an investigation period, during which values of a parameter are to be recorded. The starting and ending times may each be defined, for example, by a calendar date and a time of day, or otherwise. In some cases, an investigation period may be selected in accordance with one or more periods of use of the electrical network. For example, the investigation period may include an expected period of peak consumption by a load (e.g., industrial facility, residence or residential area, or other load) that is connected to a feeder line of the electrical network. In other examples, the investigation period may include a cycle of activity that is expected to include both periods of peak consumption and periods of reduced consumption (e.g., a period of 24 hours, or otherwise).

The investigation period may be further divided into time sections of varying lengths. The lengths of the time sections may vary from a minimum value to a maximum value. For example, the lengths of the time sections may range from about one minute to the entire length of the investigation period. During each time section, the intelligent electronic device may perform measurements of one or more electrical parameters. The intelligent electronic device calculates a representative value of each measured parameter during the each time section. For example, the representative value may include a root mean square value of the parameter.

An intelligent electronic device (e.g., a processor of the intelligent electronic device) may be configured to apply a sliding window algorithm to calculate an average value in a selected time section (e.g., depending on a particular intended application of the data) of each of the measured parameters (e.g., of the root mean square values) for a plurality of sliding window time intervals of different lengths.

For example, the duration of a sliding window time interval of minimal length may the duration of a single sampling period. Therefore, the calculated value of a measured parameter within a sliding window with such a minimal sliding window time interval is the root mean square value of that parameter for a single sampling period. The calculated value of the parameter is calculated for each position of the sliding window within a defined selected time section. For example, a first value is calculated for the first cycle within the selected time section, the second value is calculated for the second cycle within the selected time section, and so on until a value is calculated for the last cycle within the selected time section.

The durations of longer sliding window time intervals may each include a larger number of sampling periods up to a maximum time interval that is appropriate for a particular application. A maximum size of a selected sliding window time interval may be equal to the duration of a selected time section. For example, for a sampling period of one cycle of 60 Hz alternating current, and when the selected time section is 9 seconds, the maximum size of the sliding window time interval is 5400 cycles (or 450 cycles for a sampling period of one cycle of 50 Hz alternating current).

In some examples, a sliding window algorithm running on an intelligent electronic device may be configured to increase the duration of the sliding window time interval in successive iterations in steps of the duration of the sampling period.

For example, in a first iteration, the intelligent electronic device may calculate n values of the measured parameter for an entire selected time section whose duration is n sampling periods long with a sliding window time interval of one sampling period. In a second iteration, the intelligent electronic device may calculate n-1 values of the parameter for the entire selected time section for a sliding window time interval of two sampling periods. In the second iteration, as the sliding window advances from the beginning to the end of the selected time section, each calculated value is the average of the measured parameter in two adjacent sampling periods. For example, the first calculated value may represent the average of the parameter in the first and second sampling periods within the selected time section, the second value may represent the average in the second and third sampling periods, and so on until the *n-*1 value represents the average in sampling periods n-1 and n.

Similarly, in a third iteration, the intelligent electronic device may calculate n-2 average values with a sliding window time interval of three sampling periods, and so on, until calculating in an nth iteration a single average value in all of the sampling periods within the selected time section with a sliding window time interval of n sampling periods.

In other examples, the change in length of the sliding window time interval from iteration to iteration may increase by more than one sampling period, the minimum length of the sliding window time interval may be more than one sampling period, and the maximum length of the sliding window time interval may be less than n sampling periods.

For each iteration with a sliding window time interval of given length, the intelligent electronic device may be configured to select or calculate a representative value. Typically, the representative value may be a maximum (or other percentile) value of the average within the sliding window time interval for each iteration over the selected time section. The calculated or selected representative value of the parameter for each iteration may be stored in a memory or data storage of the intelligent electronic device.

The representative values may be displayed or otherwise presented to a user, e.g., on a display device that is associated with a controller of the electrical network, or otherwise. The representative values may be utilized by the controller in allocating resources of the electrical network in an efficient fashion, in planning a network, or in determining usage of the network (e.g., for billing or monitoring purposes).

For example, limits on electric current in part of the electrical network, such as a feeder line or other component of the electrical network, may be a function of duration. For example, a reference current may be determined for that component. The reference current may represent an expected average current, or may be otherwise defined or selected. It may be assumed that a measured current that does not exceed the reference current is acceptable, regardless of its duration. On the other hand, a measured current that exceeds the reference current may be acceptable only for a duration that becomes shorter with increasing excess measured current. For example, the excess measured current may be expressed as an excess current ratio, defined as the ratio of measured current to reference current.

For example, a protection relay may be configured to open a circuit breaker when a particular value of the excess current ratio (that exceeds 1) persists for a predetermined tripping duration. A shorter, safe duration for each value of the excess current ratio (greater than 1) may be defined. For example, when an particular value of the excess current ratio is measured to persist for a time that is equal to (or exceeds) the safe duration, the intelligent electronic device may issue a warning (e.g., that is communicated to a network operator) or may communicate relevant information to a controller of the electrical network, in order to ensure that the measured current is reduced prior to persisting for the tripping duration.

For example, a representative value of a parameter as calculated for an iteration with a particular sliding window time interval may be indicative of that value persisting for a duration that is equal to the length of that sliding window time interval. In particular, where the representative value is the maximum average electric current (or, equivalently, where the voltage is constant, electrical power consumption) for each sliding window time interval, the representative value may be understood as indicating that the maximum electric current persisted for a duration that is equal to the sliding window time interval.

Monitoring an electrical network with an intelligent electronic device as described herein may thus facilitate timely identification of a situation where consumption of electric current may be approaching the capacity of the electrical network to reliably provide electric current. In the example where the representative value is the maximum average electric current, continuous monitoring of the electrical network with the intelligent electronic device may identify when an excess current ratio is approaching the safe duration for that current ratio.

A method of monitoring an electrical network may be advantageous over other methods of monitoring an electrical network. For example, a typical method for monitoring an electrical network could calculate an average value of a parameter for a period 15 minutes. Typically, the starting time of each 15-minute period would be arbitrarily selected. For example, each 15-minute period could begin when the previous period ended, regardless of the pattern of electrical power consumption. Therefore, such monitoring could miss events where the duration of a current excess is shorter than 15 minutes but approaches or exceeds the safe duration for that current excess. Thus, no action may be taken to ensure that the duration of the current excess does not equal or exceed the tripping duration, possibly interrupting the electrical power supply to one or more feeder lines or loads.

On the other hand, monitoring the electrical network with intelligent electronic devices as described herein, where representative values are calculated using sliding windows with different sliding window time intervals, may detect events where the duration of an excess current ratio approaches the safe duration. Thus, resources of the electrical network may be managed in a timely fashion to prevent an excess current from tripping a circuit breaker and interrupting service to one or more users or electrical power loads.

Furthermore, use of sliding windows may enable a more accurate representation of electrical power usage, e.g., for more accurate billing, monitoring, or resource allocation.

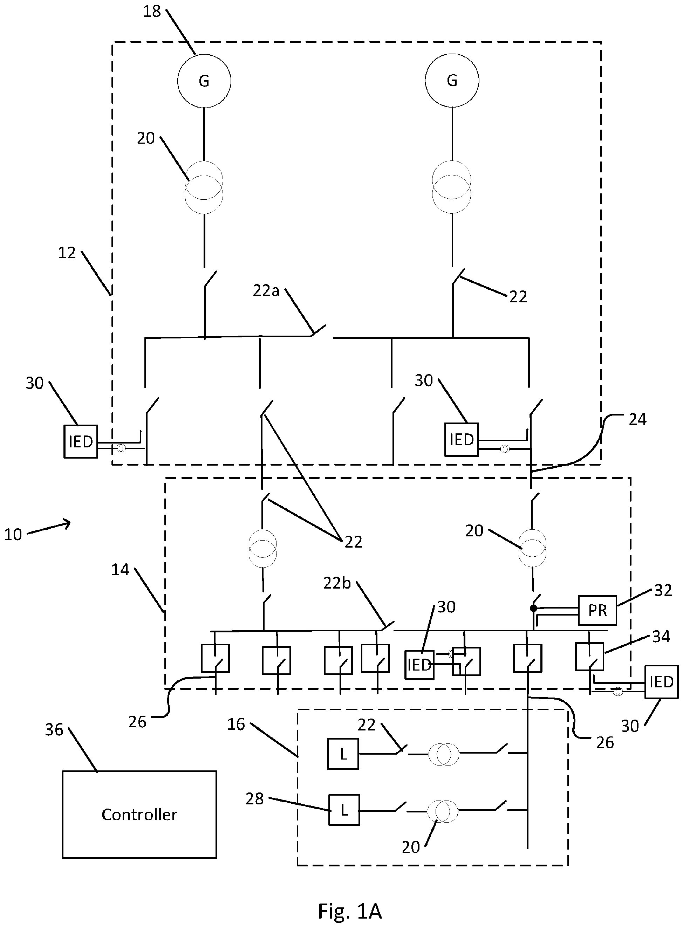

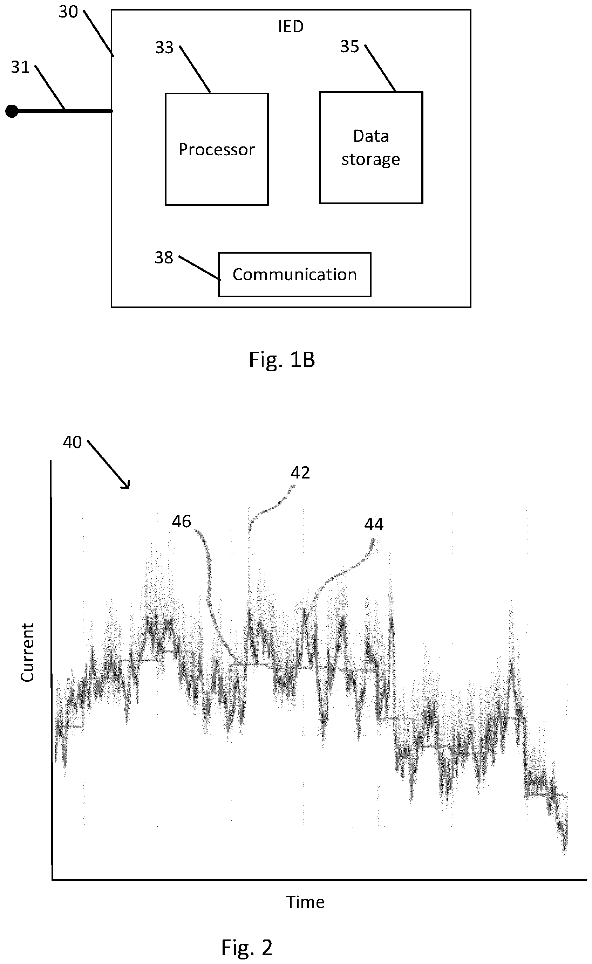

Fig. 1A schematically illustrates an electrical network that is monitored in accordance with an embodiment of the invention. Fig. 1B schematically illustrates an intelligent electronic device for monitoring the electrical network in accordance with an embodiment of the invention.

In the example shown, electrical network 10 includes power station 12, substation 14, and distribution grid 16. It may be noted that Fig. 1A includes a single power station 12, substation 14, and distribution grid 16 for the purpose of clarity. A typical electrical network may typically include a plurality of power stations 12, substations 14, and distribution grids 16.

Power station 12 may include one or more generators 18. A generator 18 may include a turbine that is powered by combustion of a fuel, by heat generated by a nuclear reactor or by solar or geothermal power, by wind or tidal power, by ocean wave action, or otherwise. A generator 18 may include a photoelectric array, an electrochemical reactor, or other source of electrical power.

Electrical power may be transmitted from power station 12 to one or more substations 14 via transmission lines 24. Electrical power may be transmitted to one or more electrical loads 28 that are connected to distribution grid 16 via one or more feeder lines 26.

Electrical network 10 may include one or more transformers 20 to convert a voltage to another voltage. For example, within power station 12, a transformer 20 may convert a voltage that is produced by a generator 18 to a voltage (e.g., a higher voltage) suitable for long-distance transmission along a transmission line 24. Similarly, a transformer 20 of a substation 14 may convert the voltage of a transmission line 24 to a (e.g., lower) voltage suitable for distribution via a feeder line 26. Other transformers 20 may convert a voltage of a feeder line 26 to a voltage suitable for connection to an electrical load 28.

Electrical network 10 may include one or more switches 22. Switches 22 may be controlled, e.g., by network controller 36 or otherwise. For example, one or more switches 22 may be operated to facilitate efficient and effective operation of electrical network 10. For example, a switch 22 such as switch 22a may be operated to change a connection between a generator 18 and a transmission line 24. Similarly, a switch 22 such as switch 22b may be operated to change a connection between a transmission line 24 and a feeder line 26. Other switches 22 may be operated, e.g., to disconnect an electrical load 28 from electrical network 10, or to otherwise prevent flow of electric current through a transmission line 24, feeder line 26, or other line of electrical network 10. For example, electric current may be interrupted for the purpose of maintenance or repair, or for another purpose.

One or more circuit breakers 34 may be configured to interrupt transmission of electrical power along a line, e.g., along a feeder line 26 or a transmission line 24, when the electric current in that line exceeds a predetermined current. Typically, one or more circuit breakers 34 may be operated by a protection relay (PR) 32. For example, a protection relay 32 may be configured to open a circuit breaker 34 in accordance with predetermined criteria. The predetermined criteria may be selected in accordance with various characteristics of a circuit breaker 34, of the line in which electric current is interruptible by that circuit breaker 34, and of one or more electrical loads 28 to which electrical power is provided via that line. Typically, the predetermined criteria may include a relationship between a ratio of a measured electric current to an expected electric current (e.g., which that line is configured to carry for an unlimited duration), and the duration of a measured electric current that exceeds the expected electric current.

One or more intelligent electronic devices (IED) 30 are configured to monitor one or more electrical parameters of a component of electrical network 10. Each intelligent electronic device 30 includes a sensor 31 that is configured to measure the parameter, a processor 33 that is configured to perform calculations or other operations in accordance with programmed instructions (e.g., stored in data storage 35), data storage 35 (e.g., for storing results of measurements and calculations, as well as programmed instructions), and a communication module 38 for communicating with controller 36 or an operator of electrical network 10, or with one or more components of electrical network 10. Typically, the monitored parameters include electric current, voltage, or both. Monitored parameters may include electrical power or another quantity, typically derivable from a measured electric current and voltage. Sensor 31 of an intelligent electronic device 30 may be connected to, or placed in proximity to, the monitored component of electrical network 10. A monitored component may include for example, a transmission line 24, feeder line 26, or another component of electrical network 10.

Data storage unit 35 of intelligent electronic device 30 is configured to store the measured values. Typically, intelligent electronic device 30 is configured to generate a root mean square value of the measured parameter per sampling period, e.g., one cycle or one half cycle of the electric current within electrical network 10. In other examples, the measurements may be stored otherwise. In typical electrical networks 10, the frequency of the electric current is 50 Hz or 60 Hz, such that the duration of a cycle is 0.02 seconds or 1/60 second, respectively, and duration of a half cycle is 0.01 seconds or 1/120 second, respectively.

Data storage 35 of intelligent electronic device 30 is configured to store the measurement results. For example, intelligent electronic device 30 may be configured (e.g., by an operator of controller 36 or otherwise), to monitor electrical network 10 during a selected time section. Intelligent electronic device 30 may be configured to store measurement results during the course of one more selected time sections (of one or more durations) during an investigation period. In one example, selected time sections may extend for 1 minute, 5 minutes, 30 minutes, and 24 hours, or other durations.

In some examples, controller 36 may include a single controller (e.g., that includes one or more computers or other processors, and one or more data storage devices, input and output devices, or other components) that is configured to control one or more controllable components of electrical network 10. In some examples, functionality of controller 36 may be distributed among two or more separate controller units, e.g., each configured to control one section or component of electrical network 10. In some examples, some of the functionality of controller 36 may be provided by processors 33 of one or more intelligent electronic devices 30, protection relays 32, or other components of electrical network 10.

Cycle-by-cycle or half-cycle by half-cycle monitoring by intelligent electronic device 30 may enable more accurate monitoring of an electrical parameter of electrical network 10 than measurement of an average value over longer time intervals.

Fig. 2 schematically illustrates an example of results of a measurement of a parameter of an electrical network once per cycle, for monitoring the parameter in accordance with an embodiment of the invention.

Graph 40 schematically illustrates a series of measurements of electric current (vertical axis) as a function of time of the measurement (horizontal axis). Curve 42 depicts a measurement of the electric current with a sampling period of one cycle. Curve 44 depicts average (e.g., root mean square) measurements of electric current within each interval of 15 cycles (e.g., 0.3 seconds when the frequency of the current is 50 Hz). It may be noted that the local variance of curve 44 is noticeably less than that of curve 42. Curve 46 depicts average measurements of electric current within each interval of 500 cycles (e.g., 10 seconds when the frequency is 50 Hz), where the duration of each interval of curve 46 (width along the horizontal axis of a horizontal segment of curve 46) represents the interval whose average current is plotted on the vertical axis. It may be noted that in circumstances in which it is important to measure an accurate indication of the variation in electric current, shorter time intervals may be advantageous over longer time intervals.

Each intelligent electronic device 30 is configured to calculate representative values of the monitored parameter using sliding windows of different sliding window time intervals.

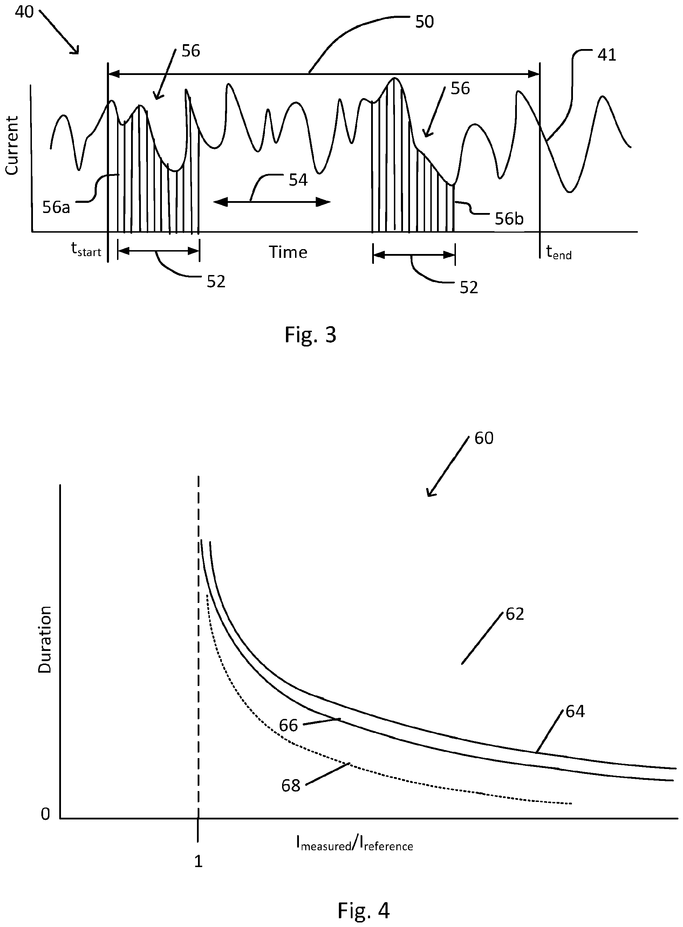

Fig. 3 schematically illustrates monitoring a parameter using sliding window calculations, in accordance with an embodiment of the invention.

Curve 41 of graph 40 represents a measured value of an electrical parameter (electric current, in the example shown), along the vertical axis, as a function of the time of measurement, along the horizontal axis. Curve 41 schematically represents the root mean square value of the parameter within each sampling period, e.g., with a duration of one half cycle of electric current. An investigation period may be defined, e.g., by an operator of electrical network 10, or automatically by controller 36 of electrical network 10. For example, starting and ending times of the investigation period may be defined by calendar date and time of day, or otherwise.

The investigation period may be divided into a plurality of selected time sections 50. The duration of selected time section 50 may be selected in accordance with characteristics of projected power consumption within electrical network 10, or within a component of electrical network 10 (e.g., substation 14, distribution grid 16, or other component). For example, possible durations of selected time section 50 may include 1 minute, 5 minutes, 30 minutes, 1 hour, 24 hours, or another duration as appropriate to a particular application. Each selected time section 50 begins at a starting time tₛₜₐᵣₜ and ending time t_{end}.

An intelligent electronic device 30 is configured to measure and record values of the parameter (e.g., current or another parameter) for each sampling period, e.g., with a duration of one cycle or half cycle of alternating electric current of electrical network 10, during selected time section 50. For example, measured root mean square values of the parameter may be stored in data storage 35 of intelligent electronic device 30.

Intelligent electronic device 30 is configured to calculate average values of the *n* recorded measurements within one or more iterations of a sliding window algorithm, each iteration applying a sliding window 56 of different duration. The duration of each sliding window 56 is herein referred to as the sliding window time interval 52 of that sliding window. A sliding window time interval 52 (where n = 12 cycles in the example shown) may vary from a minimum duration of one sampling period to maximum duration that is equal to the duration of selected time section 50.

For each given duration of sliding window time interval 52, a starting time of sliding window 56 is incremented successively by a predetermined increment from one end of selected time section 50 to the other, as represented by arrow 54. The increment may be a positive increment in which the starting time is increased, may be a negative increment in which the starting time is decreased, or may be a variable increment. At each successive starting time of sliding window 56, an average value of a recorded parameter (or of each of a plurality of different parameters) is calculated. For example, during a iteration with a sliding window 56 with a sliding window time interval 52 of n sampling periods, the starting time of sliding window 56 may be incremented by steps of a single sampling period within selected time section 50, and the average value of the parameter is calculated for each starting time of sliding window 56. In this example, if the duration of selected time section 50 is m sampling periods, and sliding window time interval 52 is *n* sampling periods, during a single iteration, *n-m*+1 average values are calculated. Thus, during an iteration where sliding window time interval 52 is equal to one sampling period, n average values are calculated. When sliding window time interval 52 has a maximum duration of m sampling periods, a single average value is calculated for each parameter.

An initial position (starting time) of sliding window 56 may include a recorded measurement at starting time tₛₜₐᵣₜ and the following n recorded measurements (typically, one per cycle) within sliding window time interval 52. The average value of the parameter may be calculated for those n recorded measurements. The starting time of the next position of sliding window 56 may be incremented by a predetermined time interval or increment, typically the duration of a single sampling period. The average value of the parameter may then be calculated at each successive position of sliding window 56. A final position of sliding window 56 may include the n-1 recorded measurements immediately preceding t_{end} in addition to the final measurement recorded at t_{end} (e.g., with starting time of n-1 sampling periods before t_{end}). Two positions of sliding window 56 are indicated by sliding window position 56a and by sliding window position 56b.

It may be noted that this chronological order of successive starting times of sliding window 56 within selected time section 50, beginning at tₛₜₐᵣₜ and ending at t_{end}, is described for convenience only. Other orders of the calculations of average values of the parameter may be utilized. For example, the position of sliding window 56 may be incremented in reverse chronological order (a negative increment) or in any other selected order.

Processor 33 of intelligent electronic device 30 may be configured to select and store in data storage 35 a representative value of the parameter for each iteration with each duration of sliding window time interval 52. In some cases, e.g., where the purpose of the measurement is to protect one or more components of electrical network 10, e.g., to prevent a protection relay 32 from interrupting provision of electrical power to one or more electrical loads 28 by opening a circuit breaker 34, a representative value of interest may be a maximum value for each iteration. In other applications, the representative value of the measured parameter may be an average value, a minimum value, a particular percentile value (e.g., other than the maximum), or another calculated or selected representative value.

Fig. 4 schematically illustrates a graph of a protection curve for use with monitoring an electrical network, in accordance with an embodiment of the invention.

The horizontal axis of graph 60 indicates a ratio of a measured value of a parameter, e.g., a measured electric current I_{measured} as measured by an intelligent electronic device 30 in a component (e.g., a transmission line 24, feeder line 26, or other line or component) of electrical network 10, to an expected or acceptable value of the parameter, e.g., expected current I_{expected}. The vertical axis indicates a duration during which the measured value persisted. (In some examples, one or both of the axes of graph 60 may be logarithmic.)

Forbidden region 62 of graph 60 represents situations that has been determined (e.g., by a designer or operator of electrical network 10, or automatically by controller 36 in accordance with predetermined criteria) to be not acceptable in electrical network 10. In the example shown, forbidden region 62 represents a measured excess current (where I_{measured} is greater than I_{expected}, or, equivalently, I_{measured}/ I_{expected} > 1) that persists for an excessive duration.

Current limit curve 64 represents conditions for which a protection relay 32 is configured to open a circuit breaker 34. For each value of excess measured current (I_{measured} / I_{expected} > 1) along the horizontal axis, current limit curve 64 indicates a duration of that excess measured current that, when detected by a protection relay 32, will result in opening of a circuit breaker 34. It may be noted that when the measured current does not exceed the expected current (I_{measured} / I_{expected} ≤ 1), there is no limitation on the duration of that measured current.

Safety curve 66 represents a desired limit of duration of excess current in order to ensure a continued supply of electrical power to all electrical loads 28. Safety curve 66 represents a more stringent limit than current limit curve 64.

In some examples, a graph 60 may include one or more probability curves 68, each indicating a probability of occurrence of an event of excess current that persists for longer than the indicated duration.

An intelligent electronic device 30 may facilitate compliance of electrical network 10 with the requirements of safety curve 66.

It may be noted that with prior art techniques of monitoring electric current in a network, as discussed above, measurements are typically limited to averages over 15-minute durations, or another fixed duration. Therefore, in some cases, if a large excess current were to persist for a shorter duration than the fixed measurement duration, the excess current could go undetected.

On the other hand, an intelligent electronic device 30 may be configured to calculate representative maximum values for multiple iterations with different sliding window time intervals 52. Thus, the duration of sliding window time interval 52 for which a particular representative maximum value of excess current is calculated indicates the duration of that excess current. When the duration of a measured excess current exceeds, equals, or approaches the allowable duration indicated by safety curve 66, an alert may be sent to controller 36 or to an operator of electrical network 10. Action may then be taken to reduce the risk of interruption of service. For example, controller 36 or the operator may operate one or more switches 22 to better match generated power to electrical loads 28, may modify operation of a power station 12, may limit operation of an electrical load 28, or may otherwise operate to prevent interruption of service.

In another example, calculation of representative values of a measured parameter by an intelligent electronic device 30 may enable synchronization of the measured parameter with patterns of usage of electrical network 10.

As described above, a typical prior art technique may define arbitrarily or randomly a 15-minute or other periods of measurement. This could be for purposes of billing or for monitoring.

On the other hand, an intelligent electronic device 30 performing calculations using sliding windows 56 could be configured to optimally match a monitoring period of predetermined duration to operation of electrical network 10.

Output from an intelligent electronic device 30 may be otherwise utilized.

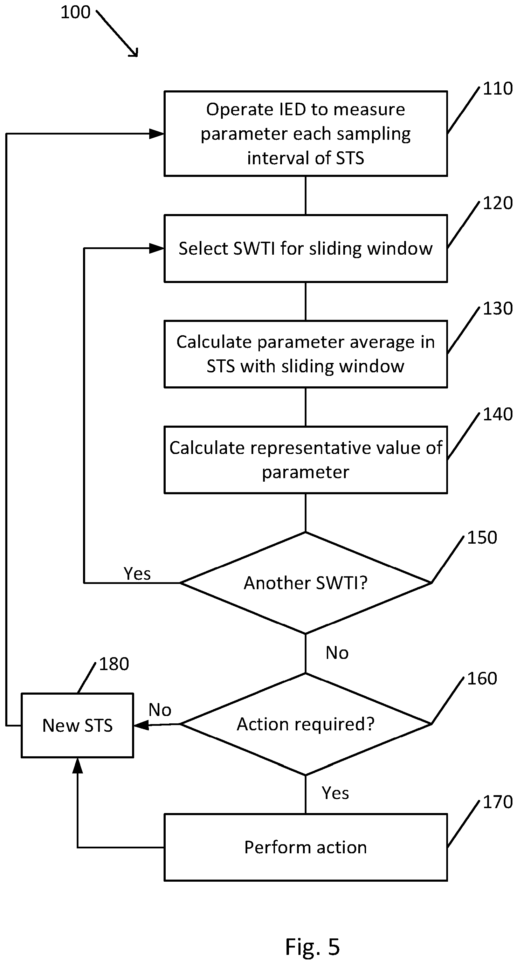

Fig. 5 is a flowchart depicting a method of monitoring a parameter of an electrical network, in accordance with an embodiment of the invention.

It should be understood with respect to any flowchart referenced herein that the division of the illustrated method into discrete operations represented by blocks of the flowchart has been selected for convenience and clarity only. Alternative division of the illustrated method into discrete operations is possible with equivalent results. Such alternative division of the illustrated method into discrete operations should be understood as representing other embodiments of the illustrated method.

Similarly, it should be understood that, unless indicated otherwise, the illustrated order of execution of the operations represented by blocks of any flowchart referenced herein has been selected for convenience and clarity only. Operations of the illustrated method may be executed in an alternative order, or concurrently, with equivalent results. Such reordering of operations of the illustrated method should be understood as representing other embodiments of the illustrated method.

Parameter monitoring method 100 may be executed by an intelligent electronic device 30 that is configured to monitor one or more electrical parameters in one or more components of an electrical network 10, e.g., by processor 33 of intelligent electronic device 30. In some cases, one or more operations of parameter monitoring method 100 may be executed by a controller 36 of electrical network 10. Parameter monitoring method 100 may be executed continuously during successive selected time sections 50 (STS) of predetermined duration, or may be executed during a predefined investigation period that is divided into one or more selected time sections 50.

During the course of a selected time section 50, processor 33 of an intelligent electronic device 30 that is connected to a monitored component of electrical network 10 may operate sensor 31 of intelligent electronic device 30 to measure values of one or more monitored parameters at frequent sampling periods, typically once per half cycle of electric current or voltage (block 110). The measurements are stored at least temporarily in a memory or data storage component of intelligent electronic device 30, e.g., data storage 35. The monitored component may include, for example, a transmission line 24, feeder line 26, or another line or component of electrical network 10. The monitored parameters typically include at least electric current, and may include voltage, electric power, or other parameters that characterize operation of a component of electrical network 10. Typically, the measured value is in the form of a root mean square of the parameter over the course of one sampling period. The measured values of a monitored parameter may be compressed to facilitate storage of the measurements.

Processor 33 may select a duration of a sliding window time interval (SWTI) 52 for an average calculated using a sliding window algorithm over the measured parameter values (block 120). The duration of a sliding window 56 for a particular iteration of the sliding window algorithm may be selected in accordance with a predetermined scheme, as determined by programmed instructions for operation of intelligent electronic device 30. For example, the duration of a minimal sliding window time interval 52 may be one sampling period, while the duration of a maximum sliding window time interval 52 may be the duration of selected time section 50.

During a iteration of a sliding window 56 of selected sliding window time interval 52 over selected time section 50, processor 33 may calculate a series of average values of the parameter over the duration of the selected sliding window time interval 52 for each starting time of sliding window 56 within selected time section 50 (block 130). Typically, the starting time of sliding window 56 is advanced or incremented by one sampling period for each calculation of the average value. In some cases, the length of the increment between successive starting times may be more than one sampling period (e.g., up to 5 seconds or 10 seconds). The number of average values that are calculated during each iteration depends on the duration of sliding window time interval 52 for that iteration, the duration of selected time section 50 (and on the difference in starting time at successive positions of sliding window 56), and the increment in starting times of sliding window 56. In some cases, a different value, other than the average, that is derived from the measured values may be calculated, instead of or in addition to the average value.

One or more representative values of the parameter may be calculated (block 140). For example, representative values may be calculated and stored for each iteration of a sliding window 56 with each duration of sliding window time interval 52.

In a first example, the representative value is a predetermined percentile value, e.g., a maximum value (100^{th} percentile), of measured electric current with each duration of sliding window time interval 52. In this first example, the duration of each sliding window time interval 52 represents the duration for which the measured maximum electric current persisted.

In a second example, the representative value may indicate a time (e.g., a position of sliding window 56) within selected time section 50 at which a maximum average value was measured.

In some examples, the representative value may indicate a correlation between two measured parameters, e.g., of a particular duration. In other examples, the representative value may indicate a variance in the parameter, an average or median value of the parameter, or another representative value of the parameter.

If a iteration within selected time section 50 is to be made with a sliding window 56 with a sliding window time interval 52 of different duration (block 150), the duration of a new sliding window time interval 52 may be selected (block 120) and the operations of blocks 130 and 140 may be repeated with the new sliding window time interval 52. For example, the duration of sliding window time interval 52 may be increased by one sampling period (or another predetermined step), may be decreased by one sampling period (or by another predetermined step), or may be otherwise changed in accordance with a predetermined sequence of durations of sliding window time interval 52.

In another example, a duration of a new sliding window time interval 52 for a particular iteration may be selected in accordance with an algorithm that selects the duration based on values of a parameter that are measured during one or more other iterations of the sliding window algorithm with other durations of sliding window time interval 52. For example, a distribution of values during previous iterations may be indicative that an accurate calculation of representative values may require finer or coarse increments in duration of sliding window time interval 52, in the increment in starting times of sliding window 56, or another characterization of an iteration with a sliding window 56.

Processor 33 may determine whether the representative values indicate a need for a particular action is required, and if so, which action (block 160). Where a need for an action is indicated, intelligent electronic device 30 may perform the action (block 170). Typically, the action includes generating a notification or alert. The alert may be sent to controller 36 for automatic action, or to an operator of electrical network 10 (e.g., via a display console), e.g., by communications module 38 of intelligent electronic device 30. The alert may include data or instructions to enable displaying the results of the calculations of intelligent electronic device 30 in graphic or tabular form, e.g., on a display screen that may be viewed by an operator, or otherwise.

For example, in the first example above, intelligent electronic device 30 or controller 36 may compare the maximum values and their durations with criteria that are represented by a safety curve 66 (or a current limit curve 64). If the duration of an excess current is too long (e.g., approaches or exceeds safety curve 66), an alert may be sent to controller 36 or an operator. Steps may then be taken by or via controller 36 to reduce the excess current.

In the second example above, the time of the maximum may be communicated to controller 36 or to the operator. Steps may then be taken to synchronize a measuring device (e.g., a meter for measuring electric power consumption) with the indicated time of the maximum.

In other examples, e.g., where an event that requires attention is detected, an alert may indicate a nature of the event. For example, controller 36 or the operator receiving the alert may determine that repairs or maintenance operations are indicated for a component of electrical network 10.

After the indicated action is performed, or if no action is indicated, and if monitoring of another selected time section 50 is indicated (block 180), intelligent electronic device 30 may begin monitoring the new selected time section 50 (return to block 110).

Different embodiments are disclosed herein. Features of certain embodiments may be combined with features of other embodiments; thus, certain embodiments may be combinations of features of multiple embodiments. The foregoing description of the embodiments of the invention has been presented for the purposes of illustration and description. It is not intended to be exhaustive or to limit the invention to the precise form disclosed. It should be appreciated by persons skilled in the art that many modifications, v <.u:ùt:vu" variations and changes are possible in light of the above teaching. It is, therefore, to be understood that the appended claims are intended to cover all such modifications and changes as fall within the scope of the invention.

While certain features of the invention have been illustrated and described herein, many modifications and changes will now occur to those of ordinary skill in the art. It is, therefore, to be understood that the appended claims are intended to cover all such modifications and changes as fall within the scope of the invention.

## Claims

1. A method of monitoring a parameter of an electrical network (10), the method comprising:
using one or a plurality of sensors (31) in the electrical network, measuring a value of a parameter of the electrical network during each sampling period within a selected time section;
using a processor, during each iteration of a plurality of iterations of a sliding window algorithm, wherein within each of the iterations a starting time of a sliding window of the sliding window algorithm within the selected time section is incremented by a selected increment, a duration of the sliding window in each iteration of the iterations being different from the duration of sliding windows in other iterations of the plurality of iterations of the sliding window algorithm, calculating an average of the measured parameter values over the duration of the sliding window for each of the starting times;
using the processor, calculating a representative value of the calculated averages of the parameter for each iteration; and
using the processor, issuing an alert if the representative value indicates a need for an alert.

2. The method of claim 1, wherein measuring a value of a parameter comprises measuring a root mean square value of the parameter.

3. The method of claim 1, wherein a duration of the sampling period is one cycle of electric current in the electrical network.

4. The method of claim 1, wherein a duration of the sampling period is one half cycle of electric current in the electrical network.

5. The method of claim 1, wherein the parameter is selected from a group of parameters consisting of electric current, voltage and electric power.

6. The method of claim 1, wherein a minimum duration of the sliding window is equal to a duration of a single sampling period.

7. The method of claim 1, wherein a maximum duration of the sliding window is 10 seconds.

8. The method of claim 1, wherein a difference between durations of the sliding windows in successive iterations of the sliding window algorithm is equal to a duration of one sampling period.

9. The method of claim 1, wherein a duration of a sliding window in an iteration of the sliding window algorithm is determined in accordance with the calculated representative value during a previous iteration of the sliding window algorithm.

10. The method of claim 1, wherein during an iteration of the sliding window algorithm, the starting time of the sliding window is incremented by the duration of one sampling period.

11. The method of claim 1, wherein the representative value comprises a predetermined percentile value of the average value of the parameter that is calculated in each iteration of the sliding window algorithm.

12. An intelligent electronic device (30) to monitor a parameter of an electrical network (10) the device including:
a sensor (31) configured to measure a value of a parameter of the electrical network during each sampling period within a selected time section; and **characterised by** a processor (33) configured to:
during each iteration of a plurality of iterations of a sliding window algorithm, wherein within each of the iterations a starting time of a sliding window of the sliding window algorithm within the selected time section is incremented by a selected increment, a duration of the sliding window in each iteration of the iterations being different from the duration of the sliding windows in other iterations of the plurality of iterations of the sliding window algorithm, calculate an average of the measured parameter values over the duration of the sliding window for each of the starting times; and
calculate a representative value of the calculated averages of the parameter for each iteration.

13. The device of claim 12, wherein a duration of the sampling period is one cycle or one half cycle of electric current in the electrical network.

14. The device of claim 12, wherein the parameter is selected from a group of parameters consisting of electric current, voltage and electric power.

15. The device of claim 12, wherein a minimum duration of the sliding window is equal to a duration of a single sampling period.

## Patentansprüche

1. Verfahren zum Überwachen eines Parameters eines elektrischen Netzes (10), wobei das Verfahren wie folgt umfasst:
Verwenden eines Sensors oder einer Vielzahl von Sensoren (31) in dem elektrischen Netz, wobei während jedes Abtastzeitraums innerhalb eines ausgewählten Zeitabschnitts ein Wert eines Parameters des elektrischen Netzes gemessen wird;
Verwenden eines Prozessors während jeder Iteration einer Vielzahl von Iterationen eines Schiebefensteralgorithmus, wobei innerhalb jeder der Iterationen eine Startzeit eines Schiebefensters des Schiebefensteralgorithmus innerhalb des ausgewählten Zeitabschnitts um einen ausgewählten Zählschritt hochgezählt wird und eine Dauer des Schiebefensters in jeder Iteration der Iterationen verschieden ist von der Dauer des Schiebefensters in anderen Iterationen der Vielzahl von Iterationen des Schiebefensteralgorithmus, Berechnen eines Mittels der gemessenen Parameterwerte über die Dauer des Schiebefensters für jede der Startzeiten;
Verwenden des Prozessors zum Berechnen eines repräsentativen Werts der berechneten Mittel der Parameter für jede Iteration; und
Verwenden des Prozessors zum Ausgeben einer Warnung, wenn der repräsentative Wert einen Warnbedarf anzeigt.

2. Verfahren nach Anspruch 1, wobei Messen eines Parameterwertes Messen eines Effektivwertes des Parameters umfasst.

3. Verfahren nach Anspruch l, wobei eine Dauer des Abtastzeitraums ein elektrischer Stromzyklus in dem elektrischen Netz ist.

4. Verfahren nach Anspruch l, wobei eine Dauer des Abtastzeitraums ein halber elektrischer Stromzyklus in dem elektrischen Netz ist.

5. Verfahren nach Anspruch l, wobei der Parameter aus einer Gruppe von Parametern bestehend aus elektrischem Strom, Spannung und elektrischer Leistung ausgewählt ist.

6. Verfahren nach Anspruch l, wobei eine Mindestdauer des Schiebefensters gleich einer Dauer eines einzelnen Abtastzeitraums ist.

7. Verfahren nach Anspruch l, wobei eine Höchstdauer des Schiebefensters 10 Sekunden ist.

8. Verfahren nach Anspruch l, wobei ein Unterschied zwischen jeweiligen Dauern der Schiebefenster in aufeinanderfolgenden Iterationen des Schiebefensteralgorithmus gleich einer Dauer eines Abtastzeitraums ist.

9. Verfahren nach Anspruch l, wobei eine Dauer eines Schiebefensters in einer Iteration des Schiebefensteralgorithmus gemäß dem berechneten repräsentativen Wert während einer vorhergehenden Iteration des Schiebefensteralgorithmus bestimmt wird.

10. Verfahren nach Anspruch l, wobei die Startzeit eines Schiebefensters während einer Iteration des Schiebefensteralgorithmus um die Dauer eines Abtastzeitraums hochgezählt wird.

11. Verfahren nach Anspruch l, wobei der repräsentative Wert einen vorbestimmten prozentualen Wert des Mittelwerts des Parameters umfasst, der bei jeder Iteration des Schiebefensteralgorithmus berechnet wird.

12. Intelligentes elektronisches Gerät (30), um einen Parameter eines elektrischen Netzes (10) zu überwachen, wobei das Gerät wie folgt aufweist:
einen Sensor (31), der dazu konfiguriert ist, um während jedes Abtastzeitraums innerhalb eines ausgewählten Zeitabschnitts einen Wert eines Parameters des elektrischen Netzes zu messen, und **gekennzeichnet durch** einen Prozessor, der wie folgt konfiguriert ist:
dass während jeder Iteration einer Vielzahl von Iterationen eines Schiebefensteralgorithmus, wobei innerhalb jeder der Iterationen eine Startzeit eines Schiebefensters des Schiebefensteralgorithmus innerhalb des ausgewählten Zeitabschnitts um einen ausgewählten Zählschritt hochgezählt wird und eine Dauer des Schiebefensters in jeder Iteration der Iterationen verschieden ist von der Dauer des Schiebefensters in anderen Iterationen der Vielzahl von Iterationen des Schiebefensteralgorithmus, ein Mittel der gemessenen Parameterwerte über die Dauer des Schiebefensters für jede der Startzeiten berechnet wird; und dass
ein repräsentativer Wert des berechneten Mittels des Parameters für jede Iteration berechnet wird.

13. Vorrichtung nach Anspruch 12, wobei eine Dauer des Abtastzeitraums ein ganzer oder ein halber elektrischer Stromzyklus in dem elektrischen Netz ist.

14. Vorrichtung nach Anspruch 12, wobei der Parameter aus einer Gruppe von Parametern bestehend aus elektrischem Strom, Spannung und elektrischer Leistung ausgewählt ist.

15. Vorrichtung nach Anspruch 12, wobei eine Mindestdauer des Schiebefensters gleich einer Dauer eines einzelnen Abtastzeitraums ist.

## Revendications

1. Procédé de surveillance d'un paramètre d'un réseau électrique (10), le procédé consistant à :
à l'aide d'un ou de plusieurs capteurs (31) dans le réseau électrique, mesurer une valeur d'un paramètre du réseau électrique pendant chaque période d'échantillonnage dans un segment temporel sélectionné ;
à l'aide d'un processeur, pendant chaque itération d'une pluralité d'itérations d'un algorithme à fenêtre glissante, dans lequel, dans chacune des itérations, un instant de début d'une fenêtre glissante de l'algorithme à fenêtre glissante dans le segment temporel sélectionné est augmenté d'un incrément sélectionné, une durée de la fenêtre glissante dans chaque itération des itérations étant différente de la durée des fenêtres glissantes dans d'autres itérations de la pluralité d'itérations de l'algorithme à fenêtre glissante, calculer une moyenne des valeurs de paramètres mesurées sur la durée de la fenêtre glissante pour chacun des instants de début;
à l'aide du processeur, calculer une valeur représentative des moyennes calculées du paramètre pour chaque itération ; et
à l'aide du processeur, émettre une alerte si la valeur représentative indique la nécessité d'une alerte.

2. Procédé selon la revendication 1, dans lequel la mesure d'une valeur d'un paramètre comprend la mesure d'une valeur quadratique moyenne du paramètre.

3. Procédé selon la revendication l, dans lequel une durée de la période d'échantillonnage est un cycle de courant électrique dans le réseau électrique.

4. Procédé selon la revendication 1, dans lequel une durée de la période d'échantillonnage est un demi-cycle de courant électrique dans le réseau électrique.

5. Procédé selon la revendication 1, dans lequel le paramètre est sélectionné parmi un groupe de paramètres constitué du courant électrique, de la tension et de la puissance électrique.

6. Procédé selon la revendication 1, dans lequel une durée minimale de la fenêtre glissante est égale à une durée d'une seule période d'échantillonnage.

7. Procédé selon la revendication 1, dans lequel une durée maximale de la fenêtre glissante est de 10 secondes.

8. Procédé selon la revendication 1, dans lequel une différence entre les durées des fenêtres glissantes dans des itérations successives de l'algorithme à fenêtre glissante est égale à une durée d'une période d'échantillonnage.

9. Procédé selon la revendication 1, dans lequel une durée d'une fenêtre glissante dans une itération de l'algorithme à fenêtre glissante est déterminée conformément à la valeur représentative calculée lors d'une itération précédente de l'algorithme à fenêtre glissante.

10. Procédé selon la revendication 1, dans lequel lors d'une itération de l'algorithme à fenêtre glissante, l'instant de début de la fenêtre glissante est augmenté de la durée d'une période d'échantillonnage.

11. Procédé selon la revendication 1, dans lequel la valeur représentative comprend une valeur percentile prédéterminée de la valeur moyenne du paramètre qui est calculée à chaque itération de l'algorithme à fenêtre glissante.

12. Dispositif électronique intelligent (30) pour surveiller un paramètre d'un réseau électrique (10), le dispositif comprenant :
un capteur (31) configuré pour mesurer une valeur d'un paramètre du réseau électrique pendant chaque période d'échantillonnage dans un segment temporel sélectionné ; et **caractérisé par** un processeur (33) configuré pour :
pendant chaque itération d'une pluralité d'itérations d'un algorithme à fenêtre glissante, dans lequel dans chacune des itérations un instant de début d'une fenêtre glissante de l'algorithme à fenêtre glissante dans le segment temporel sélectionné est augmenté d'un incrément sélectionné, une durée de la fenêtre glissante dans chaque itération des itérations étant différente de la durée des fenêtres glissantes dans d'autres itérations de la pluralité d'itérations de l'algorithme à fenêtre glissante, calculer une moyenne des valeurs de paramètres mesurées sur la durée de la fenêtre glissante pour chacun des instants de début ; et
calculer une valeur représentative des moyennes calculées du paramètre pour chaque itération.

13. Dispositif selon la revendication 12, dans lequel une durée de la période d'échantillonnage est d'un cycle ou d'un demi-cycle de courant électrique dans le réseau électrique.

14. Dispositif selon la revendication 12, dans lequel le paramètre est sélectionné parmi un groupe de paramètres constitué du courant électrique, de la tension et de la puissance électrique.

15. Dispositif selon la revendication 12, dans lequel une durée minimale de la fenêtre glissante est égale à la durée d'une seule période d'échantillonnage.
